# EUROPÄISCHE PATENTSCHRIFT

(11) **EP 1 154 486 B1**
(45) Veröffentlichungstag und Bekanntmachung des Hinweises auf die Patenterteilung: **24.02.2016**
(21) Anmeldenummer: 01111009.5
(22) Anmeldetag: 08.05.2001
(51) Int. Cl.: H01L 27/02

(54) **ESD-Schutzstruktur mit parallelen Bipolartransitoren**
ESD protection device comprising parallel bipolar transistors
Dispositif de protection contre les décharges électrostatiques comprenant des transistors bipolaires paralleles

(30) Priorität: 08.05.2000 DE 10022366
(43) Veröffentlichungstag der Anmeldung: 14.11.2001
(73) Patentinhaber: Micronas GmbH, 79108 Freiburg i. Br. (DE)
(72) Erfinder: Czech, Martin, Dipl.-Ing., 79117 Freiburg (DE); Graf, Peter, Dipl.-Ing., 79331 Teuingen-Nimburg (DE)
(74) Vertreter: Koch Müller Patentanwaltsgesellschaft mbH

(56) Entgegenhaltungen:
- EP-A- 0 575 062
- EP-A- 0 851 494
- EP-A- 0 948 051
- US-A- 5 898 206

## Beschreibung

Die Erfindung betrifft eine ESD-Schutzstruktur zum Schutz einer integrierten Halbleiterschaltung vor elektrostatischer Entladung gemäß Anspruch 1. Eine Anordnung mit den Merkmalen des Oberbegriffs des Anspruchs 1 ist aus EP 0 948 051 A2 bekannt.

Im Betrieb einer integrierten Schaltung kommt es mitunter zu unerwünscht hohen Spannungsspitzen, die über die Versorgungsspannungsleitungen in die integrierte Schaltung eingekoppelt werden. Ohne geeignete Schutzmaßnahmen können bereits parasitäre Überspannungen von wenigen Volt und dadurch verursachte elektrostatische Entladungen (engl.: electrostatic discharge (ESD)) die integrierte Schaltung irreversibel schädigen bzw. im Extremfall sogar zerstören, wodurch die Ausfallrate solcher integrierten Schaltungen unakzeptabel hoch wird:

Zur Verringerung der Ausfallrate enthalten in einem Chip integrierte Halbleiterschaltungen mitintegrierte ESD-Schutzstrukturen zum Schutz gegen elektrostatische Überspannungen. Diese ESD-Schutzstrukturen können als Klemmschaltungen zwischen den Versorgungsspannungsleitungen der integrierten Schaltung eingefügt werden und im Falle einer elektrostatischen Entladung die parasitäre Spannung auf eine der Versorgungsspannungsleitungen ableiten. Auf diese Weise kann die parasitäre Überspannung zwischen den Versorgungsspannungsleitungen auf verträgliche Werte reduziert werden.

Eine wesentliche Randbedingung bei der Herstellung von ESD-Schutzstrukturen ergibt sich aus der Forderung, dass diese unter Operationsbedingungen, wie sie beispielsweise in der Produktspezifikation beschrieben sind, die zu schützende integrierte Schaltung nicht oder nur unwesentlich beeinträchtigen dürfen. Das bedeutet, dass die Durchbruch- bzw. Durchschaltspannung eines ESD-Schutzelementes außerhalb des Signal-spannungbereichs der zu schützenden Schaltung liegen muss. Um nun eine gute Schutzwirkung entfalten zu können, sollte das ESD-Schutzelement also vor dem kritischen Schaltungspfad, jedoch noch außerhalb des Signalspannungbereichs durchbrechen. Dies erfordert in der Regel eine sehr exakte Einstellung der Durchbruch- bzw. Durchschaltspannung der jeweiligen ESD-Schutzelemente mit der wesentlichen Randbedingung, dass die Prozessführung, die hinsichtlich der Eigenschaften der Bauelemente der zu schützenden integrierten Schaltung optimiert wurde, durch das Einfügen der ESD-Schutzstruktur nicht oder nur unwesentlich verändert wird.

Als ESD-Schutzstrukturen werden zumindest teilweise sperrende Halbleiterbauelemente, wie beispielsweise Thyristoren, Dioden oder Bipolartransistoren, verwendet.

ESD-Dioden weisen jedoch den Nachteil auf, dass bei sehr hohen Strömen der Spannungsabfall über der Diode mitunter so groß werden kann, dass empfindliche Bauteile der zu schützenden Schaltung, zum Beispiel deren Gateoxide oder Diffusionsgebiete, irreversibel geschädigt werden. Darüber hinaus ist die Leistungsaufnahme der Diode im Rückwärtsbetrieb sehr groß.

Bei ESD-Thyristoren besteht die Gefahr, dass eine einmal gezündete Struktur den gezündeten Zustand unerwünschterweise beibehält. Dieser gezündete Zustand, der beliebig lange andauern kann, kann einen Kurzschluss in der Spannungsversorgung verursachen und führt in der Regel zur Zerstörung der ESD-Schutzstruktur, wodurch das Bauelement geschädigt wird.

Aus den oben genannten Gründen werden daher häufig ESD-Schutzstrukturen verwendet, die eine Vielzahl von parallel geschalteten, bipolaren Feldoxidtransistoren als ESD-Schutz aufweisen. Diese ESD-Schutzstrukturen, die sich besonders gut zur Begrenzung von parasitären Überspannungen eignen, zeigen bei umgekehrter Vorspannung in der Kennlinie zunächst ein sperrendes Verhalten, bis ein erster Spannungsdurchbruch erreicht ist, bei dem die Stroms-Spannungs-Kennlinie auf eine niedrigere Spannung als die Durchbruchspannung zurückschnappt. Dieses Zurückschnappen auf die niedrigere, sogenannte Haltespannung wird auch als Snap-back-Verhalten bezeichnet. Nach dem Erreichen der Haltespannung weist die Stroms-Spannungs-Kennlinie im Wesentlichen eine lineare Steigung auf, bis sie zu einem zweiten Spannungsdurchbruch gelangt, bei dem die ESD-Schutzstruktur zerstört wird und der daher unbedingt vermieden werden muss. Die Vielzahl der parallel angeordneten ESD-Transistoren sollten daher bei einem eingekoppelten Überspannungsimpuls möglichst gleichzeitig und gleichmäßig durchschalten.

Allerdings besteht bei solchen ESD-Schutzstrukturen die Gefahr, dass einer oder wenige der Bipolartransistoren den ganzen ESD-Strom auf sich zieht und dann aufgrund einer zu hohen Verlustleistung vorzeitig den zweiten Spannungsdurchbruch erreicht und dadurch einen Kurzschluss erleidet. Durch diesen durch inhomogenen Stromfluss verursachten Kurzschluss kann gleichermaßen die Versorgungsspannung der gesamten integrierten Halbleiterschaltung kurzgeschlossen werden, was ohne weitere Schutzmaßnahmen verheerende Folgen haben kann, die bis zur Zerstörung der integrierten Schaltung führen können. Bei der Verwendung einer Vielzahl von Transistoren als ESD-Schutz besteht somit der Bedarf, einen durch elektrostatische Überspannung verursachten ESD-Strom im Halbleiterkörper der ESD-Schutzstruktur gleichmäßig zu verteilen, um so die ESD-Schutzstruktur maximal belasten zu können und damit einen Schaden bzw. die Zerstörung der ESD-Schutzstruktur selbst zu verhindern.

Der vorliegenden Erfindung liegt daher die Aufgabe zugrunde, eine ESD-Schutzstruktur bereitzustellen, die ein möglichst gleichmäßiges Einschalten der Transistoren der ESD-Schutzstruktur gewährleistet.

Erfindungsgemäß wird diese Aufgabe durch eine ESD-Schutzstruktur mit den Merkmalen des Patentanspruchs 1 gelöst.

Die ESD-Schutzstruktur weist einen einzigen gemeinsamen Bahnwiderstand auf, der jeden Bipolartransistor ansteuert. Dieser Bahnwiderstand wird durch ein vorteilhafterweise in den Halbleiterkörper eingebrachtes tiefes Implantationsgebiet oder Diffusionsgebiet erzeugt. Diese tiefen Dotierungsgebiete wirken wie ein künstlich vergrößerter Abstand bzw. eine Barriere zwischen der Basiszone und dem Bereich, in dem die Kollektorzonen und die Emitterzonen angeordnet sind. Ladungsträger werden somit künstlich gehindert, direkt zu den Basiszonen zu diffundieren, sondern müssen einen Umweg in die Tiefe des Substrates nehmen. Die bei einem ersten Spannungsdurchbruch entstehenden Ladungsträger werden dadurch überwiegend in einem Bereich unterhalb der Emitterzonen und Kollektorzonen zurückgehalten, was einen nachfolgenden Zündprozess signifikant begünstigt. Dadurch, dass sich in dem Bereich unterhalb vom Kollektor und Emitter stets eine definierte und im Wesentlichen gleichverteilte Menge von Ladungsträgern befindet, kann ein gleichmäßiges und schnelles Zünden der Bipolartransistoren der ESD-Schutzstruktur gewährleistet werden.

Besonders vorteilhaft ist es, wenn die wannenförmigen Bereiche jeweils an den äußersten Zonen des ersten Leitungstyps, zum Beispiel den äußeren Emitterzonen, angeschlossen sind und denselben Leitungstyp wie diese (Emitter-)Zonen aufweisen. Die wannenförmigen Bereiche liegen dann auf demselben Potential wie die (Emitter-)Zonen, wodurch gewährleistet wird, dass die Ladungsträger einen deutlich grösseren Weg durch das Substrat des Halbleiterkörpers zurücklegen müssen, um zu den Basiszonen zu gelangen. Typischerweise weisen die wannenförmigen Bereiche jedoch eine deutlich geringere Dotierungskonzentration wie die angeschlossenen (Emitter-)Zonen auf. Es wäre auch denkbar - wenngleich nicht so vorteilhaft - wenn die wannenförmigen Bereiche undotiert sind oder ein Dielektrikum enthalten.

Besonders vorteilhaft ist es, wenn die wannenförmigen Bereiche sehr viel tiefer in den Halbleiterkörper hineinragen als diejenige (Emitter-)Zonen, an die sie angrenzen oder angeschlossen sind. In diesem Fall können die wannenförmigen Bereiche durch eine Tiefimplantation, beispielsweise durch eine Mehrfachionenimplantation, oder durch eine Diffusion mit anschließendem tiefen Eintreibeschritt hergestellt worden sein. Denkbar wäre hier auch ein gängiger Trenchätzprozess und Auffüllen mit dotiertem oder undotiertem Polysilicium oder mit einem Dielektrikum.

Typischerweise werden die Emitterzonen und die Kollektorzonen von den Basiszonen und den wannenförmigen Bereichen lateral umschlossen, wodurch ein besserer Latch-Up-Schutz für die ESD-Schutzstruktur gewährleistet ist. Dieser Latch-UP-Schutz kann weiter verbessert werden, indem sämtliche Zonen der ESD-Struktur - dass heißt die Emitterzonen, die Kollektorzonen, die Basiszonen und die wannenförmigen Bereiche - in eine zusätzliche Wanne eingebettet sind und somit vom Substratpotential abgetrennt sind.

In einer vorteilhaften Ausgestaltung der Erfindung sind die Emitterzonen und Kollektorzonen streifenförmig ausgebildet. Die streifenförmigen Kollektorzonen und Emitterzonen sind dann parallel nebeneinander angeordnet, wobei sich Kollektorzonen und Emitterzonen gegenseitig abwechseln. In einer Weiterbildung dieser Anordnung weist die ESD-Schutzstruktur ein im Wesentlichen quadratisches Layout auf, wodurch eine signifikante Homogenisierung des Stromes der ESD-Struktur gewährleistet wird. Eine weitere Homogenisierung des Stromes kann dadurch erzielt werden, dass die Emitterzonen und Kollektorzonen von den jeweiligen Elektroden durchgehend kontaktiert sind.

Besonders vorteilhaft ist es in diesem Zusammenhang, wenn die streifenförmigen Emitterelektroden und die Kollektorelektroden mit derjenigen Leiterbahn, mit der sie verbunden sind, jeweils eine fingerartige Struktur bilden, die dann ineinander verschränkt sind. Auf diese Weise wird gewährleistet, dass die größten Stromdichten und somit die größten Spannungsabfälle an gegenüberliegenden Seiten der jeweiligen Leiterbahnen entstehen, wodurch durch Spannungsdurchbrüche verursachte Verbrennungen an den Leiterbahnen signifikant reduziert werden.

Die erfindungsgemäße ESD-Schutzstruktur eignet sich insbesondere bei als Feldoxidtransistoren ausgebildeten Bipolartransistoren.

Vorteilhafte Ausgestaltungen und Weiterbildungen sind den Unteransprüchen, der Beschreibung und den Figuren der Zeichnung entnehmbar.

Die Erfindung wird nachfolgend anhand der in den Figuren der Zeichnung angegebenen Ausführungsbeispiele näher erläutert. Es zeigt dabei:
- Figur 1: eine Schaltungsanordnung mit einer erfindungsgemäßen ESD-Schutzstruktur;
- Figur 2: ein Schaltbild der in Fig. 1 gezeigten erfindungsgemäßen ESD-Schutzstruktur bestehend aus drei Bipolartransistoren;
- Figur 3: in einem Teilschnitt ein Ausführungsbeispiel der in Fig. 2 gezeigten ESD-Schutzstruktur;
- Figur 4: in einer Draufsicht ein vorteilhaftes Layout zur Kontaktierung von Emitter, Basis und Kollektor der ESD-Schutzstruktur entsprechend Figur 3;
- Figur 5: in einer Draufsicht eine vorteilhafte Anordnung der Leiterbahnen zur Kontaktierung der Emitterelektroden und der Kollektorelektroden.

In allen Figuren der Zeichnung sind gleiche bzw. funktionsgleiche Elemente mit gleichen Bezugszeichen versehen worden.

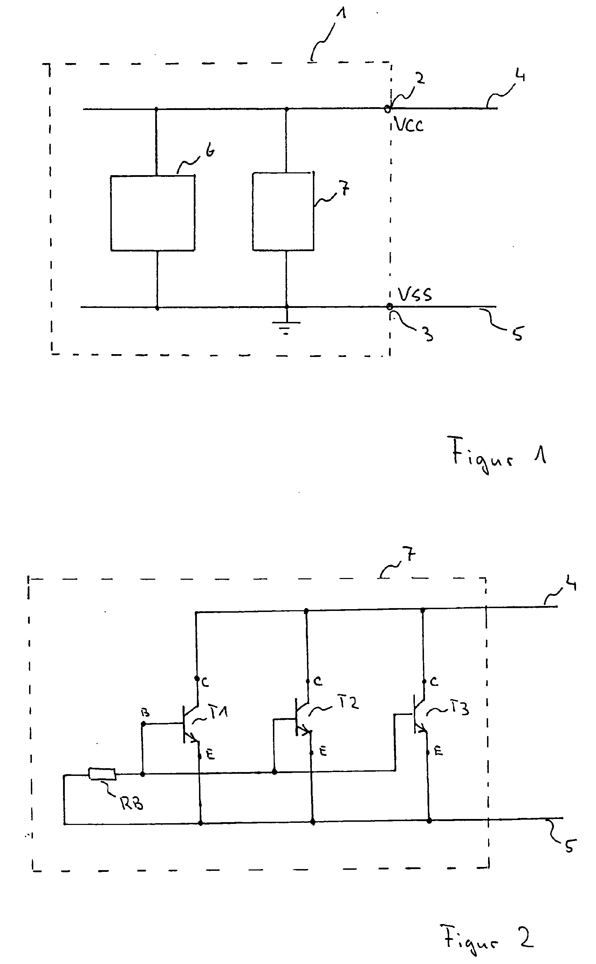

Fig. 1 zeigt eine Schaltungsanordnung mit einer erfindungsgemäßen ESD-Schutzstruktur. In Fig. 1 ist mit 1 die integrierte Halbleiterschaltung bezeichnet. Die integrierte Halbleiterschaltung 1 ist über seine beiden Versorgungspannungseingänge 2, 3 mit einer ersten Potentialschiene 4 mit einem ersten Versorgungspotential VCC sowie einer zweiten Potentialschiene 5 mit einem zweiten Versorgungspotential VSS, dass im vorliegenden Beispiel das Potential der Bezugsmasse ist, verbunden.

Die integrierte Halbleiterschaltung 1 weist ferner eine zu schützende Schaltung 6, beispielsweise eine Logikschaltung, eine programmgesteuerte Einheit, einen Halbleiterspeicher, eine Leistungsschaltung, etc., auf. Ferner weist die integrierte Halbleiterschaltung 1 eine ESD-Schutzstruktur 7 zum Schutz der zu schützenden Schaltung 6 auf. Die zu schützende Schaltung 6 sowie die ESD-Schutzstruktur 7 sind jeweils zwischen die Potentialschienen 4, 5 geschaltet. Der erfindungsgemäße Aufbau der ESD-Schutzstruktur 7 bzw. vorteilhafte Weiterbildungen werden nachfolgend anhand der Figuren 2 bis 5 ausführlich beschrieben.

Fig. 2 zeigt eine Schaltungsanordnung der in Fig. 1 gezeigten, erfindungsgemäßen ESD-Schutzstruktur. Die ESD-Schutzstruktur 7 weist drei bipolare Feldoxidtransistoren T1, T2, T3 auf. Die Bipolartransistoren T1 - T3 sind über ihre Laststrecken parallel angeordnet und zwischen den Potentialschienen 4, 5 geschaltet, wobei im vorliegenden Ausführungsbeispiel die jeweiligen Emitteranschlüsse E mit dem Potential der Bezugsmasse VSS und die jeweiligen Kollektoranschlüsse C mit dem Versorgungspotential VCC verbunden sind. Erfindungsgemäß sind die Basisanschlüsse B der Bipolartransistoren T1 - T3 miteinander kurzgeschlossen und über einen Bahnwiderstand RB an das Bezugspotential VSS und somit die Emitteranschlüsse E gekoppelt.

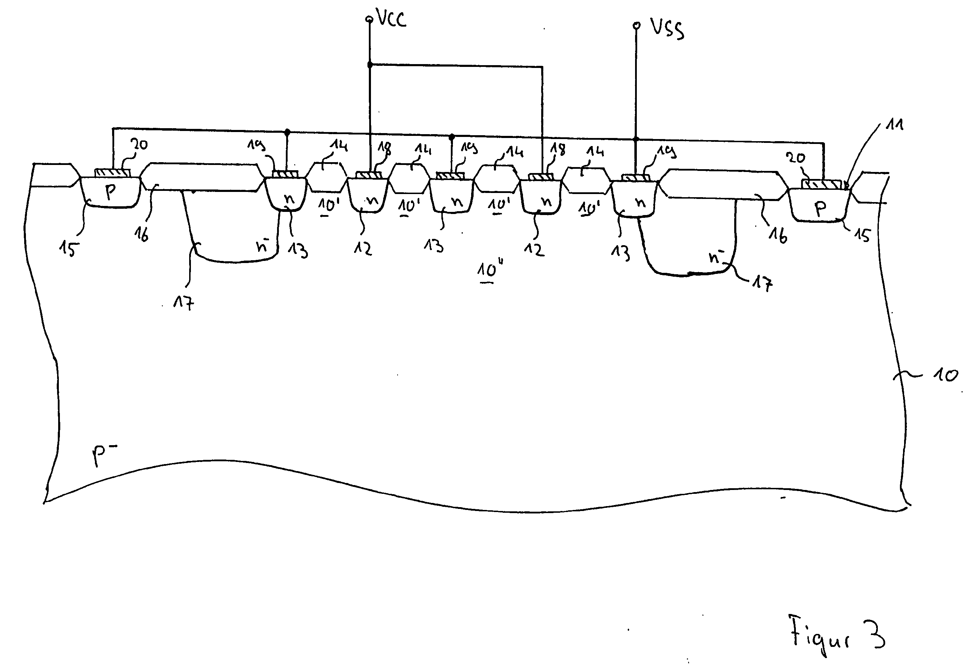

Fig. 3 zeigt in einem Teilschnitt die in Fig. 2 dargestellte ESD-Schutzstruktur. In Fig. 3 ist mit 10 ein Ausschnitt eines Halbleiterkörpers bezeichnet. Der Halbleiterkörper 10 besteht im vorliegenden Ausführungsbeispiel aus schwach p-dotiertem Siliziumsubstrat. Der Halbleiterkörper 10 weist eine Scheibenvorderseite 11 auf, in der erste und zweiten n-dotierte Bereiche 12, 13 eingebettet sind. Die ersten n-dotierten Bereiche 12 sind im vorliegenden Ausführungsbeispiel die Kollektorzonen, die zweiten n-dotierten Bereiche 13 sind die Emitterzonen. Kollektorzonen 12 und Emitterzonen 13 sind an der Oberfläche 11 abwechselnd angeordnet und voneinander durch jeweils eine Substratzone 10' bzw. ein Feldoxid 14 beabstandet. Ferner sind p-dotierte Bereiche 15, die hier die Basiszonen bilden, in den Halbleiterkörper 10 eingebettet. Diese Basiszonen 15 umschließen die Kollektorzonen 12 und Emitterzonen 13 und sind von diesen beispielsweise ebenfalls durch ein Feldoxid 16 beabstandet.

Die Kollektorzonen 12, die Emitterzonen 13 und die Basiszonen 14 sind an der Oberfläche 11 des Halbleiterkörpers 10 jeweils über Kontaktelektroden 18, 19, 20 kontaktiert. Die Kollektorelektroden 18 sind miteinander kurzgeschlossen und mit dem ersten Versorgungspotential VCC verbunden. Die Emitterelektroden 19 und die Basiselektroden 20 sind ebenfalls miteinander kurzgeschlossen und mit dem Potential der Bezugsmasse VSS verbunden.

Erfindungsgemäß sind zwischen den Basiszonen 15 und den äußeren n-dotierten Bereichen 12, 13 - im vorliegenden Ausführungsbeispiel sind das die äußeren Emitterzonen 13 - wannenförmige Bereiche 17 in den Halbleiterkörper 10 eingebracht, die an die äußeren Emitterzonen 13 angeschlossen sind. Die wannenförmigen Bereiche 17 weisen hier denselben Leitungstyp, jedoch eine geringere Dotierungskonzentration als die Emitterzonen 13 auf.

Wesentlich hierbei ist, dass die lateralen und/oder vertikalen Ausmaße der wannenförmigen Bereiche 17 derart ausgeformt sind, dass die effektive Driftstrecke von Ladungsträgern zwischen den p-dotierten Basiszonen 15 und den Substratzonen 10' im Halbleitersubstrat 10 deutlich verlängert wird. Vorteilhafterweise sind also die Bereiche 17 deutlich tiefer in den Halbleiterkörper 10 eingebracht worden, als die entsprechenden Emitterzonen 13 und/oder Kollektorzonen 12.

Nachfolgend wird die Funktionsweise der erfindungsgemäßen ESD-Schutzstruktur 7 näher beschrieben. Die schwach n-dotierten wannenförmigen Bereiche 17 sind erfindungsgemäß mit den äußeren n-dotierten Emitterzonen 13 verschmolzen und weisen somit auch deren Potential, dass heißt das Bezugspotential VSS, auf. Diese wannenförmigen Bereiche 17, die je nach verwendetem Technologieprozess durch eine Hochenergieionenimplantation oder eine tiefe Diffusion erzeugt werden können, hindern die bei einem ersten Spannungsdurchbruch entstehenden Ladungsträger von einem raschen Abdiffundieren in das Substrat und somit in die Basiszonen, da der effektive Weg zu diesen als Substratkontakt dienenden Basiszonen 15 durch den wannenförmigen Bereich 17 deutlich verlängert wird. Dadurch wird der Bereich 10" unterhalb der Emitterzonen 13 und Kollektorzonen 12 relativ schnell mit Ladungsträgern aufgefüllt, was einen nachfolgenden Zündprozess signifikant begünstigt. Dadurch, dass sich in dem Bereich 10" stets eine definierte und im Wesentlichen gleichverteilte Menge von Ladungsträgern befindet, kann ein gleichmäßiges und schnelles Zünden der Bipolartransistoren T1-T3 der ESD-Schutzstruktur 7 gewährleistet werden. Auf diese Weise wird ein einheitlicher und deutlich erhöhter gemeinsamer Basiswiderstand RB für alle Bipolartransistoren T1 - T3 der ESD-Schutzstruktur 7 erzielt.

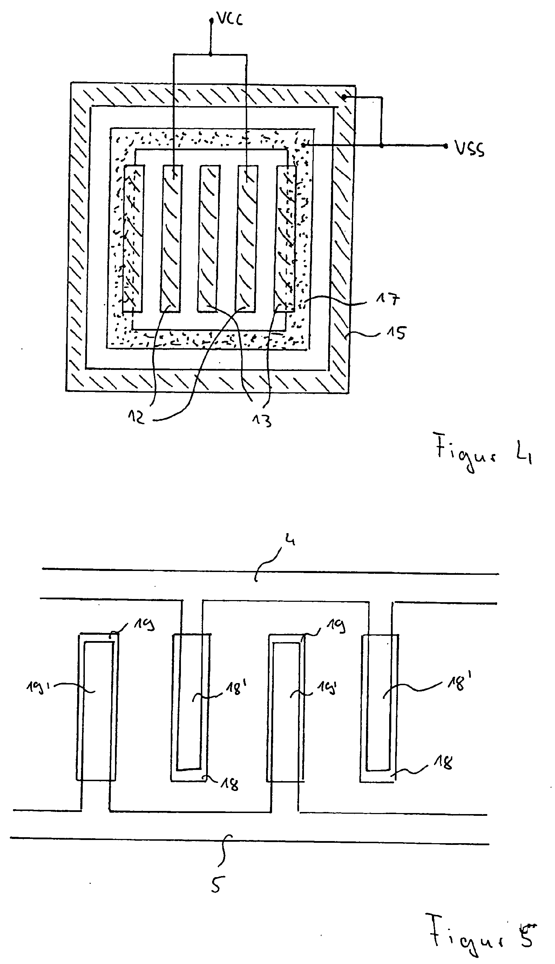

Figur 4 zeigt in einer Draufsicht ein vorteilhaftes Layout einer ESD-Schutzstruktur 7 entsprechend Figur 2. Die gesamte ESD-Schutzstruktur 7 weist hier ein im Wesentlichen quadratisches Layout auf, das zusätzlich eine gleichmäßige Stromverteilung auf die verschiedenen Bipolartransistoren T1-T3 begünstigt. Durch das quadratische Layout, bei dem die Emitterzonen 13 und die Kollektorzonen 12 streifenförmig ausgebildet und parallel nebeneinander angeordnet sind, wird sichergestellt, dass keiner der Bipolartransistoren T1-T3 grundsätzlich andere Substrateffekte "zu sehen bekommt", als der jeweils benachbarte Bipolartransistor T1-T3. Darüber hinaus wird bei einem quadratischen Layout verhindert, dass der Spannungsabfall der Kontaktmetallisierung zu groß wird und dadurch eine ungleichmäßige Stromverteilung, wie dies beispielsweise bei einem stark rechteckförmigen Layout der Fall wäre, zustande kommt.

Die Erfindung ist jedoch nicht ausschließlich auf quadratische Layouts der ESD-Schutzstrukturen 7 beschränkt, sondern kann, wenngleich auch nicht so vorteilhaft, auch bei rechteckförmigen, runden oder ovalen, hexagonalen oder ähnlichen Layouts eingesetzt werden. Darüber hinaus müssen die Emitter- und Kollektorzonen 12, 13 nicht notwendigerweise streifenförmig und nebeneinander angeordnet sein, sondern können vorteilhafterweise auch kreisringförmig, quadratisch, mäanderförmig, fächerförmig oder ähnlich angeordnet sein. Vorteilhafterweise sind die Emitterzonen 13, Kollektorzonen 12 und Basiszonen 15 durch die jeweiligen Elektroden 18, 19, 20 soweit wie möglich durchgehend kontaktiert, um so eine weitere Homogenisierung des Stromflusses zu ermöglichen.

Figur 5 zeigt in einer Draufsicht eine vorteilhafte Anordnung der Leiterbahnen zur Kontaktierung der Emitterelektroden und der Kollektorelektroden.

Figur 5 zeigt dabei die beiden Metallisierungen für die Potentialschienen 4, 5. Ferner zeigt Figur 5 die jeweils streifenförmig und nebeneinander angeordneten Emitterelektroden 19 und Kollektorelektroden 18. Diese Elektroden 18, 19 sind über fingerförmige Metallisierungen 18', 19' mit der jeweils ihr zugeordneten Potentialschiene 4, 5 verbunden. Die Metallisierungsfinger 18', 19' sind ineinander verschränkt angeordnet und jeweils an den einander gegenüberliegenden Potentialschienen 4, 5 angeschlossen.

Die beim Betrieb der ESD-Schutzstruktur 7 an deren Elektroden 18, 19 unvermeidbaren Spannungsabfälle gestalten sich üblicherweise so, dass gerade an den Stirnenden der Elektroden 18, 19 die größten Spannungsdifferenzen zwischen Emitter und Kollektor auftreten, wodurch es dort zu den höchsten Stromdichten und somit zu durch Verbrennung bedingten Ausfällen der Elektroden 18, 19 kommen kann. Mit der entsprechend Figur 5 dargestellten Anordnung der Metallisierungsfinger 18', 19' ist dies weitestgehend ausgeschlossen, da die Metallisierungsfinger 18', 19' lediglich an einer der gegenüberliegenden Potentialschienen 4, 5 angeschlossen sind. Es treten hier zwar immer noch Spannungsabfälle entlang der jeweiligen Metallisierungen auf, jedoch treten diese im vorliegenden Ausführungsbeispiel bei einer abwechselnden Kollektorelektrode 18 und Emitterelektrode 19 in gegensinniger Richtung auf, so dass eine Spannungsdifferenz zwischen Kollektorelektrode 18 und Emitterelektrode 19 immer gleich bleibt. Darüber hinaus wird durch die layoutbedingte Maßnahme entsprechend Figur 5 eine homogenere Stromverteilung auf die gesamte Fläche der ESD-Schutzstruktur 7 begünstigt.

Ein weiteres Ausführungsbeispiel, das in den Figuren der Zeichnung nicht dargestellt wurde, bietet die Möglichkeit, dass eine ESD-Schutzstruktur gemäß Fig. 2 bis 5 nebeneinander beliebig häufig angeordnet wird. Es ist hier darauf zu achten, dass die p-dotierten Basiszonen 15 stets außen angeordnet sind und die Kollektorzonen 12 und Emitterzonen 13 umschließen. Dadurch, dass die Basiszonen 15 die Zonen 12, 13 vollständig umschließen, wird die ESD-Schutzstruktur 7 ringsherum auf einem definierten Potential gehalten, wodurch ein verbesserter Latch-Up-Schutz gewährleistet werden kann. Es wäre jedoch auch denkbar, dass die Basiszonen 15 die Zonen 12, 13 nicht vollständig umschließen, jedoch bietet eine solche Struktur ein geringeren latch-up-Schutz.

Die in den Ausführungsbeispielen beschriebene ESD-Schutzstruktur weist lediglich drei Bipolartransistoren T1 -T3 auf; im Layout weist diese ESD-Schutzstruktur somit drei Emitterfinger und zwei Kollektorfinger auf. Selbstverständlich lässt sich die vorliegende Erfindung auch mit mehr oder weniger Bipolartransistoren T1-T3 realisieren. Wesentlich ist hier lediglich die Symmetrierung, das heißt, dass Emitterzonen 13 und Kollektorzonen 12 möglichst symmetrisch zueinander angeordnet sind. Darüber hinaus sollten die Emitter möglichst außen liegen, um parasitäre Randeffekte auszuschließen.

Die in Figur 3 gezeigten Basiszonen 15, Kollektorzonen 12 und Emitterzonen 13 können durch Diffusion oder durch Ionenimplanation in den Halbleiterkörper 10 eingebracht werden, jedoch richtet sich die verwendete Dotierungsmethode im Wesentlichen nach den jeweiligen Herstellungsprozessen zur Herstellung der integrierten Schaltung.

Für das Ausführungsbeispiel der Figur 3 lassen sich selbstverständlich durch Austauschen der Leitfähigkeitstypen n gegen p neue mögliche Ausführungsbeispiele bereitstellen. Ferner soll der Vollständigkeit halber noch darauf hingewiesen werden, dass die lateralen und vertikalen Dimensionierungen in Figur 3 selbstverständlich nicht maßstabsgetreu dargestellt wurden. Vielmehr wurden zum Zwecke der besseren Übersicht die vertikalen Ausmaße im Vergleich zu den lateralen Dimensionen stark vergrößert dargestellt.

Die vorstehend beschriebene ESD-Schutzstruktur 7 vermeidet die eingangs genannten Probleme des imhomogenen Stromflusses mit einhergehender schneller Zerstörung der ESD-Schutzstruktur. Diese Lösung des Problems wird nahezu ausschließlich mit Layoutmitteln erreicht und erfordert somit keine teuren Sonderprozesse oder Sondermasken. Es ist hier lediglich ein geringfügiger Mehraufwand an Chipfläche erforderlich, wodurch jedoch die Selbstschutzwirkung der beschriebenen ESD-Schutzstruktur in erheblichen Maße gesteigert werden kann.

Die erfindungsgemäße ESD-Schutzstruktur eignet sich insbesondere bei MOS-/CMOS-integrierten Halbleiterschaltungen, die einen Schutz der Versorgungsspannungsleitungen und auch der Eingänge bzw. Ausgänge benötigen. Dies sind insbesondere alle integrierten Schaltungen mit analogen und digitalen Funktionen mit eigener analoger Versorgungsspannung, insbesondere solche Schaltungen, die mit hoher Betriebsspannung arbeiten und somit keinen Eigenschutz besitzen.

Zusammenfassend kann festgestellt werden, dass durch die wie beschrieben aufgebaute und betriebene erfindungsgemäße ESD-Schutzstruktur nahezu ohne Mehraufwand, dass heißt vorteilhafterweise durch das Einfügen lediglich einer Tiefimplantation bzw. einer Diffusion für den wannenförmigen Bereich, ein optimaler ESD-Schutz mit einfachen Mitteln gewährleistet ist, ohne dass gleichzeitig die Nachteile der mit einer Vielzahl von Bipolartransistoren ausgestatteten ESD-Schutzstruktur nach dem Stand der Technik in Kauf genommen werden muss.

Die vorliegende Erfindung wurde anhand der vorstehenden Beschreibung so dargelegt, um das Prinzip der Erfindung und dessen praktische Anwendung am besten zu erklären.

### Bezugszeichenliste

- 1: integrierte Halbleiterschaltung
- 2: Versorgungsspannungseingang
- 3: Versorgungsspannungseingang
- 4: erste Potentialschiene
- 5: zweite Potentialschiene
- 6: zu schützende Schaltung
- 7: ESD-Schutzstruktur

- 10: Halbleiterkörper
- 10': Bereiche zwischen benachbarten Emitter- und Kollektorzonen, Substratzone
- 10": Bereiche unterhalb der Emitter-/Kollektorzonen
- 11: Oberfläche des Halbleiterkörpers
- 12: Kollektorzonen
- 13: Emitterzonen
- 14: Feldoxid
- 15: Basiszonen
- 16: Feldoxid
- 17: wannenförmige Bereiche
- 18: Kollektorelektrode
- 18': fingerförmige Kollektormetallisierung
- 19: Emitterelektroden
- 19': fingerförmige Emittermetallisierung
- 20: Basiselektroden

- B: Basisanschluss
- C: Kollektoranschluss
- E: Emitteranschluss
- RB: (Basis-)Bahnwiderstand
- T1, T2, T3: Bipolartransistoren
- VCC: erstes Versorgungspotential
- VSS: zweites Versorgungspotential, Potential der Bezugsmasse

## Patentansprüche

1. ESD-Schutzstruktur zum Schutz einer zwischen einer ersten Potentialschiene (4) mit einem ersten Versorgungspotential (VCC) und einer zweiten Potentialschiene (5) mit einem zweiten Versorgungspotential (VSS) geschalteten, integrierten Halbleiterschaltung (1) vor elektrostatischer Entladung, mit einer Mehrzahl von lateral ausgebildeten Bipolartransistoren (T1 - T3), deren Laststrecken parallel zueinander und zwischen den Potentialschienen (4, 5) angeordnet sind und deren Steueranschlüsse (B) an einer der Potentialschienen (4, 5) angeschlossen sind, und
ein einziger in den Halbleiterkörper (10) mitintegrierter, dotierter wannenförmiger Bereich (17) als Bahnwiderstand (RB) vorgesehen ist, der jedem Steueranschluss (B) der Bipolartransistoren (T1 - T3) vorgeschaltet ist, und in den Halbleiterkörper mindestens eine Emitterzone (13) und mindestens eine Kollektorzone (12) des ersten Leitungstyps und mindestens eine Basiszone (15) des zweiten, entgegengesetzten Leitungstyps eingebettet sind, wobei zwischen den Zonen (12, 13) des ersten Leitungstyps und den Basiszonen (15) jeweils der wannenförmige Bereich (17) in den Halbleiterkörper (10) eingebracht ist,
**dadurch gekennzeichnet, dass**
der wannenförmige Bereich (17) jeweils an eine der Zonen (12, 13) des ersten Leitungstyps angeschlossen ist, und die gleiche Dotierung, jedoch eine geringere Dotierungskonzentration als die Zonen (12, 13) aufweist, so dass die effektive freie Weglänge von Ladungsträgern zu den Basiszonen (15) verlängert ist.

2. ESD-Schutzstruktur nach Anspruch 1, **dadurch gekennzeichnet, dass** der wannenförmige Bereich (17) sehr viel tiefer in den Halbleiterkörper (10) hineinragt als diejenige Zone (12, 13), an die er angrenzt oder angeschlossen ist.

3. ESD-Schutzstruktur nach Anspruch 1 oder 2, **dadurch gekennzeichnet, dass** die Basiszonen (15) und die wannenförmigen Bereiche (17) die Emitterzonen (13) und die Kollektorzonen (13) lateral umschließen.

4. ESD-Schutzstruktur nach einem der Ansprüche 1 bis 3, **dadurch gekennzeichnet, dass** der Halbleiterkörper (10) Ladungsträger vom ersten Leitungstyp aufweist und in den Halbleiterkörper (10) mindestens eine weitere Wanne des zweiten Leitungstyps eingebettet ist, in der die Emitterzonen (13), Kollektorzonen (12), Basiszonen (15) und wannenförmigen Bereiche (17) eingebettet sind.

5. ESD-Schutzstruktur nach einem der Ansprüche 1 bis 5, **dadurch gekennzeichnet, dass** die Emitterzonen (13) und Kollektorzonen (12) streifenförmig derart ausgebildet sind, dass sie abwechselnd nebeneinander und parallel zueinander angeordnet sind.

6. ESD-Schutzstruktur nach einem der vorstehenden Ansprüche, **dadurch gekennzeichnet, dass** die ESD-Schutzstruktur (7) ein im Wesentlichen quadratisches Layout aufweist.

7. ESD-Schutzstruktur nach einem der vorstehenden Ansprüche, **dadurch gekennzeichnet, dass** die Emitterzonen (13) von den Emitterelektroden (19) und die Kollektorzonen (12) von den Kollektorelektroden (18) durchgehend kontaktiert sind.

8. ESD-Schutzstruktur nach einem der vorstehenden Ansprüche, **dadurch gekennzeichnet, dass** die Emitterelektroden (19) und die Kollektorelektroden (18) über Leiterbahnen (19`, 18') an jeweils einer gegenüberliegenden Potentialschiene (4, 5) angeschlossen sind und somit fingerförmige Anschlüsse bilden, die ineinander verschränkt sind.

9. ESD-Schutzstruktur nach einem der vorstehenden Ansprüche, **dadurch gekennzeichnet, dass** die Bipolartransistoren (Ti - T3) als Feldoxidtransisitoren ausgebildet sind.

## Claims

1. Electrostatic discharge protective structure for protection of an integrated semiconductor circuit (1), which is connected between a first potential rail (4) with a first supply potential (VCC) and a second potential rail (5) with a second supply potential (VSS), from electrostatic discharge, with a plurality of laterally constructed bipolar transistors (T1 - T3), the load paths of which are arranged parallel to one another and between the potential rails (4, 5) and the control terminals (B) of which are connected with one of the potential rails (4, 5), and a single doped trough-shaped region (17) is provided integrally in the semiconductor body (10) as a path resistance (RB), which is connected upstream of each control terminal (B) of the bipolar transistors (T1 - T3), and embedded in the semiconductor body is at least one emitter zone (13) and at least collector zone (12) of the first conductor type and at least one base zone (15) of the second, opposite conductor type, wherein the trough-shaped region (17) is formed in the semiconductor body (10) respectively between the zones (12, 13) of the first conductor type and the base zones (15), **characterised in that** the trough-shaped region (17) is respectively connected with one of the zones (12, 13) of the first conductor type and has the same doping as, but a smaller doping concentration than the zones (12, 13) so that the effective free path length of the charge carriers to the base zones 915) is prolonged.

2. Electrostatic discharge protective structure according to claim 1, **characterised in that** the trough-shaped region (17) protrudes much more deeply into the semiconductor body (10) than that zone (12, 13) which it adjoins or with which it is connected.

3. Electrostatic discharge protective structure according to claim 1 or 2, **characterised in that** the base zones 915) and the trough-shaped regions (17) laterally surround the emitter zones (13) and the collector zones (13).

4. Electrostatic discharge protective structure according to any one of claims 1 to 3, **characterised in that** the semiconductor body (10) has charge carriers of the first conductor type and at least one further trough of the second conductor type, in which the emitter zones (13), collector zones (12), base zones (15) and trough-shaped regions (17) are embedded, is embedded in the semiconductor body (10).

5. Electrostatic discharge protective structure according to any one of claims 1 to 5, **characterised in that** the emitter zones (13) and collector zones (12) are of such strip-shaped construction that they are arranged in alternation adjacent to and parallel to one another.

6. Electrostatic discharge protective structure according to any one of the preceding claims, **characterised in that** the electrostatic discharge protective structure (7) has a substantially square layout.

7. Electrostatic discharge protective structure according to any one of the preceding claims, **characterised in that** the emitter zones (13) are contacted continuously by the emitter electrodes (19) and the collector zones (12) continuously by the collector electrodes (18).

8. Electrostatic discharge protective structure according to any one of the preceding claims, **characterised in that** the emitter electrodes (19) and the collector electrodes (18) are connected by way of conductor tracks (19', 18') respectively to an opposite a potential rail (4, 5) and thus form finger-shaped terminals which are interlaced in one another.

9. Electrostatic discharge protective structure according to any one of the preceding claims, **characterised in that** the bipolar transistors (T1 - T3) are constructed as field oxide transistors.

## Revendications

1. Dispositif de protection contre les décharges électrostatiques pour la protection d'un circuit à semi-conducteurs (1) intégré, connecté entre un premier rail de potentiel (4) avec un premier potentiel d'alimentation (VCC) et un deuxième rail de potentiel (5) avec un deuxième potentiel d'alimentation (VSS), contre une décharge électrostatique, comprenant une multitude de transistors bipolaires à configuration latérale (T1 - T3), dont les zones de charge sont agencées parallèlement l'une à l'autre et entre les rails de potentiel (4, 5) et dont les bornes de commande (B) sont raccordées à l'un des rails de potentiel (4, 5) et il est prévu une seule région (17) en forme de cuvette, dopée, intégrée dans le corps de semi-conducteur (10) comme résistance de ligne (RB), qui est connectée en amont de chaque borne de commande (B) des transistors bipolaires (T1 - T3), et au moins une zone d'émetteur (13) et au moins une zone de collecteur (12) du premier type de conductivité et au moins une zone de base (15) du deuxième type de conductivité opposé sont noyées dans le corps de semi-conducteur, dans laquelle la zone en forme de cuvette (17) est chaque fois introduite dans le corps de semi-conducteur (10) entre les zones (12, 13) du premier type de conductivité et les zones de base (15), **caractérisée en ce que** la zone en forme de cuvette (17) est raccordée respectivement à l'une des zones (12, 13) du premier type de conductivité et présente le même dopage, cependant une concentration de dopage moindre que les zones (12, 13), de telle manière que la longueur de chemin libre effective de porteurs de charge vers les zones de base (15) soit prolongée.

2. Structure de protection contre les décharges électrostatiques selon la revendication 1, **caractérisée en ce que** la zone en forme de cuvette (17) pénètre beaucoup plus profondément dans le corps de semi-conducteur (10) que dans la zone (12, 13) dont elle est voisine ou à laquelle elle est raccordée.

3. Structure de protection contre les décharges électrostatiques selon la revendication 1 ou 2, **caractérisée en ce que** les zones de base (15) et les zones en forme de cuvettes (17) entourent latéralement les zones d'émetteur (13) et les zones de collecteur (13).

4. Structure de protection contre les décharges électrostatiques selon l'une quelconque des revendications 1 à 3, **caractérisée en ce que** le corps de semi-conducteur (10) présente des porteurs de charge du premier type de conductivité et au moins une autre cuvette du deuxième type de conductivité, dans laquelle les zones d'émetteur (13), les zones de collecteur (12), les zones de base (15) et les zones en forme de cuvettes (17) sont noyées, est noyée dans le corps de semi-conducteur (10).

5. Structure de protection contre les décharges électrostatiques selon l'une quelconque des revendications 1 à 5, **caractérisée en ce que** les zones d'émetteur (13) et les zones de collecteur (12) sont réalisées en forme de bandes, de telle manière qu'elles soient agencées en alternance l'une à côté de l'autre et parallèlement l'une à l'autre.

6. Structure de protection contre les décharges électrostatiques selon l'une quelconque des revendications précédentes, **caractérisée en ce que** la structure de protection contre les décharges électrostatiques (7) présente une configuration essentiellement carrée.

7. Structure de protection contre les décharges électrostatiques selon l'une quelconque des revendications précédentes, **caractérisée en ce que** les zones d'émetteur (13) sont en contact continu avec les électrodes d'émetteur (19) et les zones de collecteur (12) sont en contact continu avec les électrodes de collecteur (18).

8. Structure de protection contre les décharges électrostatiques selon l'une quelconque des revendications précédentes, **caractérisée en ce que** les électrodes d'émetteur (19) et les électrodes de collecteur (18) sont raccordées par des lignes conductrices (19', 18') respectivement à un rail de potentiel opposé (4, 5) et forment ainsi des raccords en forme de doigts qui sont imbriqués les uns dans les autres.

9. Structure de protection contre les décharges électrostatiques selon l'une quelconque des revendications précédentes, **caractérisée en ce que** les transistors bipolaires (T1 - T3) sont des transistors à effet de champ à grille métal-oxyde.
